(19) Europäisches Patentamt
European Patent Office
Office européen des brevets

(11) **EP 3 802 274 B1**

(12) **EUROPÄISCHE PATENTSCHRIFT**

(45) Veröffentlichungstag und Bekanntmachung des Hinweises auf die Patenterteilung:
**25.10.2023 Patentblatt 2023/43**

(21) Anmeldenummer: **19728966.3**

(22) Anmeldetag: **05.06.2019**

(51) Internationale Patentklassifikation (IPC):
**B62D 1/06** *(2006.01)*    **H03K 17/955** *(2006.01)*

(52) Gemeinsame Patentklassifikation (CPC):
**B62D 1/046; B62D 1/06; H03K 17/962;**
H03K 2217/96072

(86) Internationale Anmeldenummer:
**PCT/EP2019/064603**

(87) Internationale Veröffentlichungsnummer:
**WO 2019/238486 (19.12.2019 Gazette 2019/51)**

(54) **VERFAHREN ZUR ERKENNUNG EINER BERÜHRUNG EINER HANDBETÄTIGTEN LENKEINRICHTUNG, INSBESONDERE EINES FAHRZEUGLENKRADS, UND VORRICHTUNG ZUR DURCHFÜHRUNG DES VERFAHRENS**

METHOD FOR DETECTING CONTACT WITH A MANUALLY ACTIVATED STEERING DEVICE, IN PARTICULAR A VEHICLE STEERING WHEEL, AND A DEVICE FOR CARRYING OUT THE METHOD

PROCÉDÉ DE RECONNAISSANCE D'UN CONTACT SUR UN DISPOSITIF DE DIRECTION MANUEL, EN PARTICULIER UN VOLANT DE DIRECTION D'UN VÉHICULE, ET DISPOSITIF PERMETTANT LA MISE EN OUVRE DU PROCÉDÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.06.2018 DE 102018113879**

(43) Veröffentlichungstag der Anmeldung:
**14.04.2021 Patentblatt 2021/15**

(73) Patentinhaber: **ZF Automotive Safety Germany GmbH**
**63743 Aschaffenburg (DE)**

(72) Erfinder:
• **HIRZMANN, Guido**
**63877 Sailauf (DE)**

• **SCHILLINGER, Michael**
**63743 Aschaffenburg (DE)**

(74) Vertreter: **Gerschütz, Florian Matthias**
**ZF Friedrichshafen AG**
**Corporate Intellectual Property**
**Löwentaler Strasse 20**
**88046 Friedrichshafen (DE)**

(56) Entgegenhaltungen:
**DE-A1-102009 055 424    DE-A1-102014 016 422**
**DE-A1-102015 216 095    US-A1- 2005 239 075**
**US-A1- 2012 326 735    US-A1- 2014 151 356**
**US-A1- 2018 106 924**

**Beschreibung**

Die Erfindung betrifft eine Vorrichtung zur Erkennung einer Berührung einer handbetätigten Lenk- oder Steuereinrichtung, insbesondere eines Fahrzeuglenkrads. Die Erfindung betrifft ferner ein Verfahren zur Erkennung mittels der Vorrichtung.

Die Kenntnis, ob der Fahrer eines Fahrzeugs gerade das Lenkrad berührt oder nicht, ist eine Information, die für verschiedene Sicherheits- und Fahrerassistenzsysteme essentiell oder zumindest nützlich ist. Grundsätzlich gibt es verschiedene technische Möglichkeiten, wie eine Lenkradberührung detektiert werden kann. Bislang sind insbesondere Vorrichtungen bekannt, bei denen kapazitive oder resistive Sensoren in das Lenkrad integriert sind.

Für bestimmte anspruchsvolle Anwendungen ist es allerdings über eine bloße Berührungsdetektion hinaus erforderlich, die Berührung zu lokalisieren, d. h. es muss nicht nur eine Lenkradberührung an sich, sondern auch der Ort Berührung am Lenkrad festgestellt werden. Eine solche Ortsbestimmung ist jedoch technisch schwierig umzusetzen. Es werden dafür in der Regel zusätzliche Leitungen und Komponenten benötigt, und der Montageaufwand steigt erheblich.

Eine Vorrichtung zur Erkennung einer Berührung eines Fahrzeuglenkrads gemäß dem Oberbegriff des Anspruchs 1 ist aus US 2014/151356 A1 bekannt. Ein Verfahren zur Erkennung einer Berührung eines Fahrzeuglenkrads ist aus US 2018/106924 A1 bekannt.

Aus der DE 10 2014 016 422 A1 sind eine Vorrichtung und ein Verfahren zur Erfassung einer Lenkradberührung bekannt, die darauf basieren, dass eine im Lenkrad angeordnete erste Elektrode zusammen mit dem als zweite Elektrode fungierenden menschlichen Körper und einem dazwischenliegenden Dielektrikum einen Sensorkondensator bilden. Eine Auswerteschaltung mit einem aufgeladenen Referenzkondensator bekannter Kapazität ist parallel zu diesem Sensorkondensator schaltbar, sodass ein Teil der Ladung des Referenzkondensators auf den Sensorkondensator übertragen wird. Die für die Detektion benötigte Bestimmung der Kapazitätsänderung des Sensorkondensators erfolgt unter Einbeziehung der bekannten Kapazität des Referenzkondensators und der gemessenen Spannung am Referenzkondensator vor und nach der Parallelschaltung der Auswerteschaltung. Wenn mehrere über den Lenkradkranz verteilt angeordnete und galvanisch voneinander getrennte erste Elektroden vorgesehen sind, lassen sich Schlüsse über die konkrete Stelle der Lenkradberührung ziehen.

Die Aufgabe der Erfindung besteht darin, die Position der Berührung einer Lenk- oder Steuereinrichtung mit einfachen Mitteln genau erkennen zu können.

Gelöst wird diese Aufgabe durch eine Vorrichtung zum Erkennen einer Berührung einer handbetätigten Lenk- oder Steuereinrichtung mit den Merkmalen des Anspruchs 1 sowie durch ein Verfahren. Vorteilhafte und zweckmäßige Ausgestaltungen des erfindungsgemäßen Verfahrens und der erfindungsgemäßen Vorrichtung sind in den zugehörigen Unteransprüchen angegeben.

Das Verfahren zur Erkennung einer Berührung einer handbetätigten Lenk- oder Steuereinrichtung, insbesondere eines Fahrzeuglenkrads, umfasst folgende Schritte:

-    Anlegen einer Wechselspannung an wenigstens eine Leiteranordnung, die an der Lenk- oder Steuereinrichtung angeordnet ist und wenigstens einen Leiterstrang mit einem signifikanten ohmschen Widerstand aufweist;

-    Ermitteln des Stromverlaufs in der Leiteranordnung;

-    Ermitteln des Realanteils und des Imaginäranteils des Wechselstromwiderstands der Leiteranordnung;

-    Ermitteln der Kapazität oder der Kapazitätsänderung der Leiteranordnung;

-    Ermitteln der Phasenverschiebung (Phasenwinkel); und

-    Auswerten der ermittelten Werte.

Allgemein soll "Ermitteln" das Messen, Berechnen, sonstiges Bestimmen oder das Bekanntsein einer Größe beinhalten.

Die Erfindung beruht auf der Erkenntnis, dass es in der kapazitiven Messtechnik bereits etablierte effektive Verfahren zur Erkennung einer Kapazitätsänderung gibt. Ein erstes Grundverfahren basiert auf der Änderung der kapazitiven Kopplung einer Sensorstruktur gegenüber einer Referenzelektrode infolge einer Aktion. Ein zweites Grundverfahren basiert auf der Änderung der kapazitiven Kopplung einer Sensorstruktur gegenüber der Umgebung infolge einer Aktion. Die Erfindung erweitert diese Verfahren durch die Einbeziehung eines signifikanten Widerstands eines Leiterstrangs der Leiteranordnung. Gemäß der Erfindung hat nämlich wenigstens ein Leiterstrang der Leiteranordnung einen nennenswerten ohmschen Widerstand im Vergleich z. B. zu einer herkömmlichen Kupferdrahtleitung. Auf diese Weise ist ein durch eine Aktion wie eine Handberührung veränderbares, auswertbares RC-Glied gebildet. Bei bekannter angelegter Wechselspannung wird der Gesamtwiderstand (Impedanz) der Leiteranordnung durch Messen des Stromverlaufs ermittelt. Der Begriff "Wechselspannung" soll hier alle auf Schwingungen basierenden Spannungsverläufe umfassen, insbesondere Sinus-, Rechteck-, Dreieck-, Sägezahnschwingungen, aber auch Pulsspannungen mit aufeinanderfolgenden Spannungsimpulsen. Da sich der Gesamtwiderstand der Leiteranordnung aus einem Realanteil, der durch den ohmschen Widerstand des Leiterstrangs bestimmt ist, und einem Imaginäranteil zusammensetzt, der durch die sich ausbildende Kapazität zwischen einem anderen Leiterstrang (Referenzelektrode) oder der Umgebung bestimmt ist, kann aus dem Phasenwinkel auf die Position der Berührung der Lenk- oder Steuereinrichtung geschlossen werden.

Durch eine geschickte Anordnung und Auslegung der Leiteranordnung ist nicht nur eine genaue Positionsbestimmung möglich, sondern es können grundsätzlich auch Bewegungsmuster (Gesten) erkannt und analysiert werden. Nach erfolgreicher Interpretation kann eine der jeweiligen identifizierten Geste zugeordnete Funktion ausgelöst werden.

Da der Kern der Erfindung in der Auswertung einfach zu messender bzw. zu ermittelnder Größen liegt und im Vergleich zu anderen Berührungserkennungsvorrichtungen neben wenigen normalen Leitungen als einzige besondere Komponente lediglich ein Leitungsstrang mit signifikantem ohmschen Widerstand benötigt wird, hat die Erfindung den Vorteil, dass sie insgesamt kostengünstig ist und ohne großen Aufwand eingebaut werden kann.

Vorzugsweise werden die Schritte des erfindungsgemäßen Verfahrens fortlaufend durchgeführt. Das bedeutet, dass die Lenk- oder Steuereinrichtung ohne größere Pausen permanent überwacht wird. Dies ist eine Voraussetzung für eine zuverlässige Erkennung von Gesten.

Das Auswerten der ermittelten Werte umfasst beim erfindungsgemäßen Verfahren zusätzlich insbesondere wenigstens einen der folgenden Schritte:

- Erkennen, ob die Lenk- oder Steuereinrichtung großflächig berührt wird;

- Erkennen, ob die Lenk- oder Steuereinrichtung punktuell berührt wird;

- Grifferkennung (Art des Griffs);

- Erkennen der Anzahl gleichzeitig stattfindender Berührungen;

- Lokalisieren der Positionen mehrerer Berührungen;

- Feststellen der Dauer einer Berührung;

- Identifizieren von Gesten.

Je mehr dieser Schritte durchgeführt werden, desto vielseitiger ist das erfindungsgemäße Verfahren anwendbar.

Dank der Möglichkeit einer vielseitigen Auswertung der ermittelten Werte kann das erfindungsgemäße Verfahren dazu genutzt werden, in Abhängigkeit der Auswertung bestimmte Funktionen auszulösen.

Die Erfindung schafft auch eine Vorrichtung zur Durchführung des erfindungsgemäßen Verfahrens. Die Vorrichtung umfasst eine Lenk- oder Steuereinrichtung, insbesondere einem Fahrzeuglenkrad, eine an der Lenk- oder Steuereinrichtung angeordneten Leiteranordnung, die wenigstens einen Leiterstrang mit einem signifikanten ohmschen Widerstand aufweist, und eine in der Nähe angeordnete Steuer- und Auswerteeinrichtung. Die Steuer- und Auswerteeinrichtung ist eingerichtet zum Anlegen einer Wechselspannung an die Leiteranordnung, zur Messung des Stromverlaufs in der Leiteranordnung und zur Auswertung der ermittelten Werte. Ferner ist diese Steuer- und Auswerteeinrichtung mit dem Fahrzeug, insbesondere einer übergeordneten Steuereinheit der Bordelektronik vernetzt.

Eine "Wechselspannung" soll hier wiederum allgemein als ein auf Schwingungen basierender Spannungsverlauf verstanden werden, insbesondere eine Sinus-, Rechteck-, Dreieck-, Sägezahnschwingung, aber auch eine Pulsspannung mit aufeinanderfolgenden Spannungsimpulsen.

Das Vorsehen mehrerer, über die Lenk- oder Steuereinrichtung verteilt angeordneter Leiteranordnungen ermöglicht einerseits eine höhere Zuverlässigkeit und/oder Genauigkeit (Auflösung) bei der Berührungserkennung. Andererseits wird dadurch auch das Erkennen von Multitouch-Eingaben ermöglicht, ähnlich wie bei einem berührungsempfindlichen Display.

Vorzugsweise ist die erfindungsgemäß vorgesehene Leiteranordnung unter einer Oberfläche, insbesondere unter einer dekorativen Oberfläche, der Lenk- oder Steuereinrichtung angeordnet. Im Falle eines Fahrzeuglenkrads wäre dies z. B. unter einer Ummantelung des Lenkradkranzes. Grundsätzlich sollte die Leiteranordnung möglichst nahe an der Oberfläche platziert sein, um eine hohe Empfindlichkeit zu gewährleisten.

Gemäß einer ersten bevorzugten Ausführungsform der erfindungsgemäßen Vorrichtung weist die Leiteranordnung zwei im Wesentlichen parallel verlaufende elektrische Leiter auf, von denen wenigstens einer einen signifikanten, im Vergleich zu einem Kupferdraht deutlich höheren ohmschen Widerstand hat, vorzugsweise im Bereich von 10 Ω/m bis 1 MΩ/m. Bei dieser Ausführungsform verändert sich die kapazitive Kopplung der beiden Leiter bei der Anwesenheit einer Hand. Dank der Einbeziehung des ermittelten Gesamtwiderstands kann dann die Position der Hand bestimmt werden.

Damit es nicht zu unerwünschten Kopplungen mit benachbarten Komponenten oder Störungen kommen kann, sollten die elektrischen Leiter jeweils isoliert sein.

Die Leiteranordnung der erfindungsgemäßen Vorrichtung weist mehrere, durch elektrische Leiter in Reihe miteinander verbundene Sensorfelder in Form von elektrisch leitenden Flächen oder Bereichen auf, wobei die elektrischen Leiter zwischen den Sensorflächen bzw. -bereichen einen signifikanten ohmschen Widerstand haben. Die Leiteranordnung ist also durch eine Folge von aneinander gereihten Widerständen und Leiterflächen bzw. -bereichen gebildet. In Kombination mit einer Hand entsteht ein charakteristisches RC-Glied, dessen Verhalten durch die Steuer- und Auswerteeinrichtung so ausgewertet werden kann, dass die Position der Hand bestimmbar ist. Die Zuverlässigkeit und Genauigkeit der Berührungserkennung ist durch Anzahl, Form, Größe und Anordnung der Sensorfelder bzw. -bereiche optimierbar. Um die Kosten für die Vorrichtung niedrig zu halten, ist eine geschickte Anordnung und Auslegung der Leiteranordnung bevorzugt, sodass möglichst wenige Sensorflächen bzw. -bereiche verbaut und möglichst wenige Kabel oder Leiterbahnen verlegt werden müssen.

Gemäß einem anderen bevorzugten Aspekt der Erfindung weist der Leiterstrang einen oder mehrere gestreckte elektrische Leiter mit einem signifikanten ohmschen Widerstand auf, der bzw. die in spezifischer Art so verlegt ist bzw. sind, dass RC-Glieder gebildet sind, welche in Folge auswertbar sind.

Allgemein ist es dank der bereits erwähnten vielseitigen Auswertemöglichkeiten möglich, die Steuer- und Auswerteeinrichtung so einzurichten, dass in Abhängigkeit der Auswertung bestimmte Funktionen ausgelöst werden können. Die Vorrichtung dient in diesem Fall als komplexe Befehlseingabeeinrichtung, mit der der Bediener gezielt bestimmte Funktionen aufrufen kann.

Weitere Merkmale und Vorteile der Erfindung ergeben sich aus der nachfolgenden Beschreibung und aus den beigefügten Zeichnungen, auf die Bezug genommen wird. In den Zeichnungen zeigen:

- Figur 1 eine erste Ausführungsform einer Leiteranordnung für eine erfindungsgemäße Vorrichtung zum Erkennen einer Berührung einer handbetätigten Lenk- oder Steuereinrichtung;

- Figur 2 eine zweite Ausführungsform einer Leiteranordnung für eine erfindungsgemäße Vorrichtung zum Erkennen einer Berührung einer handbetätigten Lenk- oder Steuereinrichtung;

  Figur 3 eine dritte Ausführungsform einer Leiteranordnung für eine erfindungsgemäße Vorrichtung zum Erkennen einer Berührung einer handbetätigten Lenk- oder Steuereinrichtung; und

  Figur 4 eine vierte Ausführungsform einer Leiteranordnung für eine erfindungsgemäße Vorrichtung zum Erkennen einer Berührung einer handbetätigten Lenk- oder Steuereinrichtung.

Im Folgenden wird eine Vorrichtung zum Erkennen einer Berührung einer handbetätigten Lenk- oder Steuereinrichtung am Beispiel eines Fahrzeuglenkrads beschrieben.

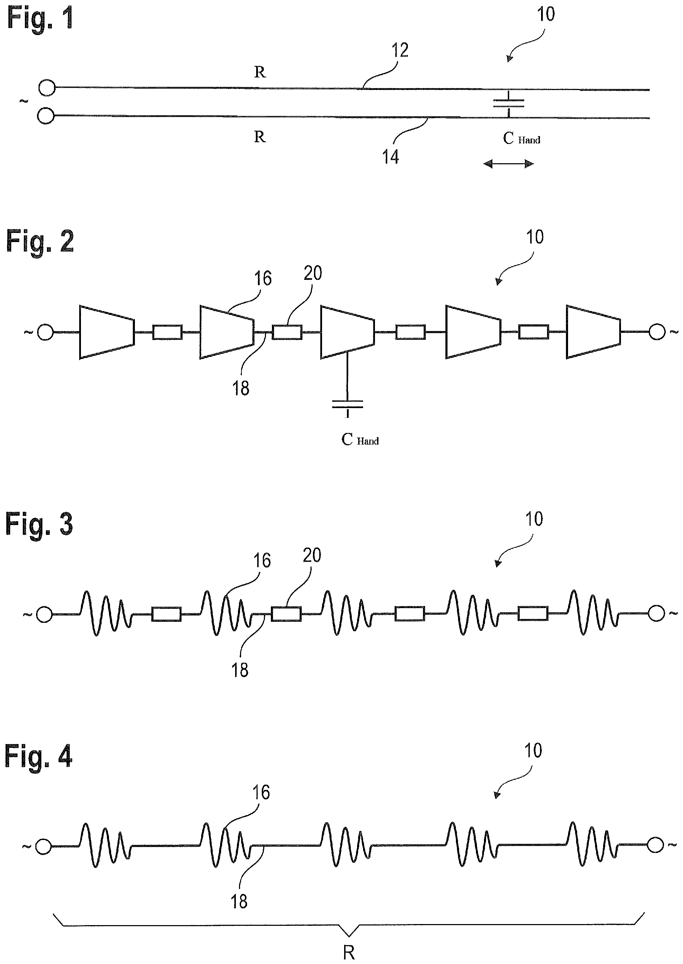

Gemäß einer ersten Ausführungsform der Vorrichtung ist im Kranz des Lenkrads, wie in Figur 1 symbolisch dargestellt, eine erste Leiteranordnung 10 mit zwei parallel verlaufenden elektrischen Leitern 12, 14 angeordnet. Genauer gesagt ist die Leiteranordnung 10 unter einer dekorativen Oberfläche des Lenkrads angeordnet, z. B. unter einer Lederummantelung.

Die Leiteranordnung verläuft über den gesamten Umfang oder wenigstens einen wesentlichen Teil des Lenkradkranzes. Alternativ sind mehrere solche Leiteranordnungen 10 vorgesehen, die jeweils in einem Teilbereich des Lenkradkranzes angeordnet sind. Außerdem können mehrere Leiteranordnungen 10 über den Torusumfang des Lenkradkranzes verteilt sein.

Die beiden Leiter 12, 14 sind mit einer Isolierung versehen, d. h. sie sind gegeneinander und gegen ihre Umgebung isoliert.

Die beiden Leiter 12, 14 bilden eine Kapazität gegeneinander aus. Im Falle zweier gleich dicker Drähte aus dem gleichen elektrisch gut leitenden Material würde sich die Kapazität C wie folgt berechnen:

$$C = \frac{\pi \varepsilon l}{arcosh\left(\frac{d}{2R}\right)}$$

mit $\varepsilon$: Dielektrizitätskonstante zwischen den Leitern
$l$: Länge der Leiter
$d$: Abstand zwischen den Leitermittelachsen
$R$: Radius der Leiterquerschnitte

Eine Besonderheit der für die hier beschriebene Vorrichtung vorgesehenen ersten Leiteranordnung 10 besteht darin, dass wenigstens ein Leitungsstrang, d. h. wenigstens einer der beiden Leiter 12, 14 im Vergleich zu einem Kupferdraht einen nennenswerten ohmschen Widerstand hat, insbesondere im Bereich von 10 Ω/m bis 1 MΩ/m. Der gesamte ohmsche Widerstand bzw. der spezifische Widerstand der Leiter 12, 14 ist einer Steuer- und Auswerteeinrichtung bekannt.

Wenn an die Leiteranordnung 10 eine Wechselspannung, also eine Spannung mit einem auf einer Schwingung basierenden Verlauf (wie etwa Sinus-, Rechteck-, Dreieck-, oder Sägezahnschwingung) oder eine Pulsspannung mit aufeinanderfolgenden Spannungsimpulsen, angelegt wird, setzt sich der Gesamtwiderstand aus einem Realanteil und einem Imaginäranteil zusammen. Der Realanteil ist durch den widerstandsbehafteten Leiter 12 bzw. 14 und der Imaginäranteil durch die sich ausbildende Kapazität zwischen den Leitern 12, 14 bestimmt. Es stellt sich ein bestimmter Phasenwinkel für den Gesamtwiderstand ein.

Wenn nun eine Hand den Leitern ganz nahe kommt, wie dies bei einer Berührung des Lenkradkranzes der Fall ist, ändert sich die Kapazität der Leiteranordnung signifikant ($C_{Hand}$). Das bedeutet, dass sich der Imaginäranteil des Gesamtwiderstands ändert und, dadurch bedingt, auch der Phasenwinkel. Diese Verstimmung kann bei bekannter Wechselspannung durch Messung des Stromverlaufs erkannt und registriert werden. Darüber hinaus lässt sich in der Steuer- und Auswerteeinrichtung aus der Änderung des Realanteils und des Imaginäranteils bzw. der Änderung des Phasenwinkels ein genauer Rückschluss auf die Position der Hand am Lenkrad ziehen.

Im Rahmen einer permanenten Überwachung durch die Steuer- und Auswerteeinrichtung lassen sich auf diese Weise nicht nur Berührungen an sich, sondern auch Bewegungsmuster (Gesten) erkennen. Die Steuer- und Auswerteeinrichtung kann bestimmte Gesten interpretieren und Funktionen auslösen, die den Gesten zugeordnet sind.

Wenn über das Lenkrad verteilt mehrere, voneinander getrennte Leiteranordnungen 10 vorgesehen sind, können mehrere gleichzeitig stattfindende Lenkradberührungen (zwei Hände am Lenkrad) unterschieden werden.

Die Anordnung der Leiteranordnung(en) 10 ist nicht auf den Lenkradkranz beschränkt, sondern kann sich auch auf die Speichen und den Mittelteil des Lenkrads erstrecken. Außerdem kann ein beliebiger, für die Auswertung vorteilhafter Verlauf der parallelen Leiter 12, 14 vorgesehen sein, z. B. ein regelmäßiger oder unregelmäßiger mäanderförmiger Verlauf.

In Figur 2 ist symbolisch eine zweite Leiteranordnung 10 dargestellt, die für eine zweite Ausführungsform der Vorrichtung zum Erkennen einer Berührung einer handbetätigten Lenk- oder Steuereinrichtung vorgesehen ist. Auch die zweite Ausführungsform wird nachfolgend am Beispiel eines Fahrzeuglenkrads beschrieben.

Die zweite Leiteranordnung 10 besteht im Wesentlichen aus einem Leiterstrang mit mehreren Sensorfeldern 16, die elektrisch leitend in Reihe miteinander verbunden sind. Die Sensorfelder 16 sind elektrisch leitende Flächen oder Bereiche, die z. B. aus Folien, Leitlacken, Drahtgeflechten, -gewirken oder anderen Drahtstrukturen gebildet sein können. Entscheidend ist, dass die Sensorfelder 16 elektrisch leitend sind und gegenüber einer Hand ein signifikantes kapazitives Feld erzeugen können.

Die elektrischen Leiter 18 zwischen den Sensorfeldern 16 haben wiederum einen ohmschen Widerstand, der signifikant über den Widerstand z. B. eines Kupferdrahts oder dergleichen hinausgeht. Dabei können entweder die Leiter 16 selbst widerstandsbehaftet sein, oder es sind elektrischen Bauelemente 20, Leiterabschnitte oder dergleichen mit einem signifikanten ohmschen Widerstand in Reihe zwischengeschaltet.

Wie bei der ersten Ausführungsform ist auch die zweite Leiteranordnung 10 unter einer dekorativen Oberfläche des Lenkrads angeordnet, z. B. unter einer Lederummantelung. Die Leiteranordnung 10 verläuft über den gesamten Umfang oder wenigstens einen wesentlichen Teil des Lenkrads. Alternativ sind mehrere solche Leiteranordnungen 10 vorgesehen, die jeweils in einem Teilbereich des Lenkradkranzes angeordnet sind.

Kommt eine Hand einem Sensorfeld der zweiten Leiteranordnung 10 ganz nahe, wie es bei einer Berührung des Lenkradkranzes der Fall ist, bildet sich eine Kapazität aus bzw. ändert sich die Kapazität ($C_{Hand}$) im Vergleich zur Kapazität zwischen der Leiteranordnung 10 und der Umgebung ohne eine in unmittelbarer Nähe befindlichen Hand. Die Anwesenheit der Hand bestimmt bzw. ändert wiederum den Imaginäranteil des Gesamtwiderstands der Leiteranordnung 10. Abhängig von der Position der Hand stellt sich ein bestimmter Phasenwinkel ein. Ähnlich wie bei der ersten Ausführungsform ist bei bekannter anliegender Wechselspannung durch eine Messung des Stromverlaufs eine Auswertung in der Steuer- und Auswerteeinrichtung möglich, die einen genauen Rückschluss auf die Position der Hand am Lenkrad zulässt.

Die Genauigkeit der Positionsbestimmung (Auflösung) hängt bei der zweiten Ausführungsform insbesondere von der Anzahl, Form, Größe und Anordnung der Sensorfelder 16 ab.

Grundsätzlich gilt für die zweite Ausführungsform bezüglich der Anordnung der zweiten Leiteranordnung 10 (Lenkradkranz, Lenkradspeichen, Lenkradmittelteil), des Vorsehens und der Verteilung mehrerer zweiter Leiteranordnungen 10 und der Gestenerkennung das Gleiche wie bei der ersten Ausführungsform.

Die Sensorfelder 16 können nicht nur kapazitiv, sondern auch induktiv, resistiv, digital (Schalter), magnetisch, optisch erzeugt und abgefragt (vermessen) werden. Auch Kombinationen sind möglich z. B. kapazitiv-resistive Sensorfelder 16.

Die Abfrage der Sensorfelder 16 kann sequenziell oder parallel erfolgen, wobei die Sensorfelder 16 einzeln oder in Gruppen abgefragt werden können.

In den Figuren 3 und 4 sind zwei weitere Leiteranordnungen 10 symbolisch dargestellt, die für eine dritte bzw. vierte Ausführungsform der Vorrichtung zum Erkennen einer Berührung einer handbetätigten Lenk- oder Steuereinrichtung vorgesehen sind.

Bei der in Figur 3 gezeigten Leiteranordnung 10 sind die Sensorfelder 16 durch gestreckte elektrische Leiter 18 gebildet, die in bestimmten Bereichen eng geschwungen oder gewunden ist oder einen sonstigen sehr stark gekrümmten Verlauf haben, der deutlich von einem geraden Verlauf abweicht. Durch einen solchen spezifischen Verlauf der elektrischen Leiter 18 bilden die Sensorflächen 16 zusammen mit den dazwischenliegenden (geraden) Leiterabschnitten, die einen signifikanten ohmschen Widerstand haben, und/oder mit dazwischengeschalteten Bauelementen 20 (elektrische Widerstandselemente oder dergleichen) einzelne RC-Glieder. Diese RC-Glieder werden in Folge ausgewertet.

Die in Figur 4 gezeigte Leiteranordnung 10 entspricht großteils der von Figur 3. Allerdings sind zwischen den Sensorfeldern 16 keine Widerstände in Form von Bauelementen oder dergleichen eingefügt. Stattdessen wird bei der Auswertung des gemessenen Stromverlaufs in der Steuer- und Auswerteeinrichtung der bekannte Gesamtwiderstand R des elektrischen Leiters 18 berücksichtigt.

Mit allen Ausführungsformen lassen sich mittels eines geeigneten Auswertealgorithmus verschiedene Arten der Berührung unterscheiden, wie etwa längeres Berühren an einer lokalisierbaren Stelle, Klopfbewegungen, Streichbewegungen (einschließlich Richtung) etc. Dadurch sind Funktionen realisierbar, die über das Erkennen einer Lenkradberührung an sich im Rahmen von Sicherheits- und Fahrerassistenzsystemen und ggf. die Erkenntnis, ob das Lenkrad sicher gegriffen wird, hinausgehen. Insbesondere ist eine Grifferkennung möglich, d. h. es kann die Art des Griffs erkannt werden, mit dem der Fahrer das Lenkrad greift bzw. umgreift.

Die wichtigsten Unterscheidungsmöglichkeiten und einige der damit eröffneten Funktionen (geeignete Platzierung und Auslegung der Leiteranordnungen 10 vorausgesetzt) sind nachfolgend beispielhaft noch einmal aufgelistet:

- allgemein das Erkennen, ob das Lenkrad mit der Hand vollständig umfasst wird oder ob das Lenkrad nur punktuell mit einem Finger berührt wird etc.;

- Erkennen einer punktuellen Berührung (z. B. Klopfen) → Interpretation als Tastendruck;

- Erkennen der Positionen von punktuellen Berührungen → Interpretation als unterschiedliche Tastendrücke;

- Erkennen der Anzahl der gleichzeitig stattfindenden Berührungen → Rückschluss auf einhändige oder beidhändige Lenkradberührung und/oder Multitouch-Eingaben;

- Erkennen der Dauer einer bestimmten Berührung → Nutzung für stufenloses Einstellen von Parametern;

- Erkennen bestimmter Gesten --> Auslösen zugeordneter Funktionen wie z. B. Blinker setzen (links, rechts), Scheibenwischer anstellen, Radiobedienung, allgemein innerhalb von Anwendungen: "Vor", "Zurück" etc.

Die beiden beschriebenen Ausführungsformen oder bestimmte Aspekte davon lassen sich selbstverständlich auch miteinander kombinieren.

Die Erfindung wurde am Beispiel eines Fahrzeuglenkrads erläutert, ist aber nicht auf diese Anwendung beschränkt. Die erfindungsgemäße Berührungserkennung kann grundsätzlich bei beliebigen handbetätigten Lenk- oder Steuervorrichtungen von Kraftfahrzeugen, Zügen, Maschinen etc. eingesetzt werden.

## Patentansprüche

1. Vorrichtung zur Erkennung einer Berührung einer handbetätigten Lenk- oder Steuereinrichtung, mit

einer Lenk- oder Steuereinrichtung, insbesondere einem Fahrzeuglenkrad,
einer an der Lenk- oder Steuereinrichtung angeordneten Leiteranordnung (10), die wenigstens einen Leiterstrang mit einem signifikanten ohmschen Widerstand aufweist, und
einer Steuer- und Auswerteeinrichtung, die eingerichtet ist

- zum Anlegen einer Wechselspannung an die Leiteranordnung (10),
- zur Messung des Stromverlaufs in der Leiteranordnung (10), und
- zur Auswertung der ermittelten Werte,

dadurch gekennzeichnet, dass die Leiteranordnung (10) mehrere, durch elektrische Leiter (18) in Reihe miteinander verbundene Sensorfelder (16) in Form von elektrisch leitenden Flächen oder Bereichen aufweist, wobei die elektrischen Leiter (18) zwischen den Sensorflächen bzw. -bereichen einen signifikanten ohmschen Widerstand haben.

2. Vorrichtung nach Anspruch 1, dadurch gekennzeichnet, dass mehrere, über die Lenk- oder Steuereinrichtung verteilt angeordnete Leiteranordnungen (10) vorgesehen sind.

3. Vorrichtung nach Anspruch 1 oder 2, dadurch gekennzeichnet, dass die Leiteranordnung (10) unter einer Oberfläche der Lenk- oder Steuereinrichtung angeordnet ist.

4. Vorrichtung nach einem der Ansprüche 1 bis 3, dadurch gekennzeichnet, dass die Leiteranordnung (10) zwei im Wesentlichen parallel verlaufende elektrische Leiter (12, 14) aufweist, von denen wenigstens einer einen signifikanten, im Vergleich zu einem Kupferdraht deutlich höheren ohmschen Widerstand hat, vorzugsweise im Bereich von 10 Ω/m bis 1 MΩ/m.

5. Vorrichtung nach Anspruch 4, dadurch gekennzeichnet, dass die elektrischen Leiter (12, 14) jeweils isoliert sind.

6. Vorrichtung nach einem der Ansprüche 1 bis 3, dadurch gekennzeichnet, dass die Leiteranordnung (10) einen oder mehrere gestreckte elektrische Leiter (18) mit einem signifikanten ohmschen Widerstand aufweist, der bzw. die in spezifischer Art so verlegt ist bzw. sind, dass RC-Glieder gebildet sind, welche in Folge auswertbar sind.

7. Vorrichtung nach einem der vorhergehenden Ansprüche, dadurch gekennzeichnet, dass die Steuer- und Auswerteeinrichtung eingerichtet ist, in Abhängigkeit der Auswertung bestimmte Funktionen auszulösen.

**8.** Verfahren zur Erkennung einer Berührung einer handbetätigten Lenk- oder Steuereinrichtung mittels einer Vorrichtung nach einem der vorstehenden Ansprüche, mit folgenden Schritten:

- Anlegen einer Wechselspannung an die wenigstens eine Leiteranordnung (10), die an der Lenk- oder Steuereinrichtung angeordnet ist und wenigstens einen Leiterstrang mit einem signifikanten ohmschen Widerstand aufweist;
- Ermitteln des Stromverlaufs in der Leiteranordnung (10);
- Ermitteln des Realanteils und des Imaginäranteils des momentanen Wechselstromwiderstands der Leiteranordnung (10);
- Ermitteln der Kapazität oder der Kapazitätsänderung der Leiteranordnung (10);
- Ermitteln der Phasenverschiebung; und
- Auswerten der ermittelten Werte.

**9.** Verfahren nach Anspruch 8, **dadurch gekennzeichnet, dass** die Verfahrensschritte fortlaufend durchgeführt werden.

**10.** Verfahren nach Anspruch 8 oder 9, **dadurch gekennzeichnet, dass** das Auswerten wenigstens einen der folgenden Schritte umfasst:

- Erkennen, ob die Lenk- oder Steuereinrichtung großflächig berührt wird;
- Erkennen, ob die Lenk- oder Steuereinrichtung punktuell berührt wird;
- Grifferkennung;
- Erkennen der Anzahl gleichzeitig stattfindender Berührungen;
- Lokalisieren der Positionen mehrerer Berührungen;
- Feststellen der Dauer einer Berührung;
- Identifizieren von Gesten.

**11.** Verfahren nach Anspruch 10, **dadurch gekennzeichnet, dass** in Abhängigkeit der Auswertung bestimmte Funktionen ausgelöst werden.

## Claims

**1.** A device for detecting contact with a manually activated steering device, comprising

a steering device, in particular a vehicle steering wheel,
a conductor arrangement (10) disposed on the steering device which includes at least one conductor line having a significant ohmic resistance, and

a control and evaluation device which is arranged

- to apply an alternating voltage to the conductor line (10),
- to measure the path of the current in the conductor arrangement (10), and
- to evaluate the determined values,

**characterized in that** the conductor arrangement (10) includes plural sensor fields (16) in the form of electrically conducting surfaces or areas connected to each other in series by electric conductors (18), wherein the electric conductors (18) have a significant ohmic resistance between the sensor surfaces and areas.

**2.** The device according to claim 1, **characterized in that** there are provided plural conductor arrangements (10) distributed over the steering device.

**3.** The device according to claim 1 or 2, **characterized in that** the conductor arrangement (10) is disposed beneath a surface of the steering device.

**4.** The device according to any one of the claims 1 to 3, **characterized in that** the conductor arrangement (10) includes two electric conductors (12, 14) extending substantially in parallel at least one of which has a significant ohmic resistance that is definitely higher compared to a copper wire, preferably ranging from 10 Ω/m to 1 MΩ/m.

**5.** The device according to claim 4, **characterized in that** each of the electric conductors (12, 14) is insulated.

**6.** The device according to any one of the claims 1 to 3, **characterized in that** the conductor arrangement (10) includes one or more elongate electric conductors (18) having a significant ohmic resistance which is/are laid in a specific manner so that RC links are formed which can be evaluated successively.

**7.** The device according to any one of the preceding claims, **characterized in that** the control and evaluation device is arranged to trigger specific functions in response to evaluation.

**8.** A method for detecting contact with a manually activated steering device by means of a device according to any one of the preceding claims, comprising the steps of:

- applying alternating voltage to the at least one conductor arrangement (10) which is disposed on the steering device and includes at least one conductor line having a significant ohmic resistance;
- determining the path of the current in the conductor arrangement (10);
- determining the real component and the imaginary component of the instantaneous AC resistance of the conductor arrangement (10);
- determining the capacitance or the change in capacitance of the conductor arrangement (10);
- determining the phase shift; and
- evaluating the determined values.

9. The method according to claim 8, **characterized in that** the method steps are carried out continuously.

10. The method according to claim 8 or 9, **characterized in that** evaluating comprises at least one of the steps of:

   - detecting whether the steering device is contacted over a large area:
   - detecting whether the steering device is contacted selectively;
   - grip detection;
   - detecting the number of contacts occurring simultaneously;
   - localizing the positions of plural contacts;
   - determining the duration of one contact;
   - identifying gestures.

11. The method according to claim 10, **characterized in that** specific functions are triggered in response to the evaluation.


**Revendications**

1. Dispositif de détection d'un contact avec un équipement de direction ou de commande à commande manuelle avec

   un dispositif de direction ou de commande, en particulier un volant de véhicule,
   un ensemble de conducteurs (10) disposé sur l'équipement de direction ou de commande, le au moins un brin conducteur possède une résistance avec une valeur ohmique significative, et
   un dispositif de contrôle et d'évaluation, qui est mis en place

      - pour appliquer une tension alternative à l'ensemble conducteur (10),
      - pour mesurer le flux de courant dans l'ensemble conducteur (10), et
      - pour évaluer les valeurs déterminées,

   **caractérisé en ce que** l'ensemble de conducteurs (10) présente plusieurs champs de capteurs (16) reliés les uns aux autres en série par des conducteurs électriques (18) en forme de surfaces ou de zones électriquement conductrices, pour lequel les conducteurs électriques (18) possèdent entre les surfaces ou zones de capteur une résistance ohmique importante.

2. Dispositif selon la revendication 1, **caractérisé en ce qu'**il est prévu une pluralité d'ensembles de conducteurs (10) répartis sur le dispositif de direction ou de commande.

3. Dispositif selon la revendication 1 ou 2, **caractérisé en ce que** l'ensemble de conducteurs (10) est disposé sous une surface du dispositif de direction ou de commande.

4. Dispositif selon l'une des revendications 1 à 3, **caractérisé en ce que** l'ensemble de conducteurs (10) présente deux conducteurs électriques essentiellement parallèles (12, 14), dont au moins un a une résistance ohmique significative, qui est nettement supérieure à celle d'un fil de cuivre, de préférence dans la plage de 10 $\Omega$/m à 1 M$\Omega$/m.

5. Dispositif selon la revendication 4, **caractérisé en ce que** les conducteurs électriques (12, 14) sont chacun isolés.

6. Dispositif selon l'une des revendications 1 à 3, **caractérisé en ce que** l'ensemble de conducteurs (10) comporte un ou plusieurs conducteurs électriques étendus (18) avec une résistance ohmique importante, qui est/sont déposée(s) de manière spécifique de manière à former des éléments RC, qui peuvent ensuite être évalués.

7. Dispositif selon l'une des revendications précédentes, **caractérisé en ce que** le dispositif de contrôle et d'évaluation est agencé pour déclencher certaines fonctions en fonction de l'évaluation.

8. Procédé de détection d'un contact d'un équipement de direction ou de commande à commande manuelle au moyen d'un dispositif selon l'une quelconque des revendications précédentes, avec les étapes suivantes :

   - Appliquer une tension alternative à l'au moins un ensemble de conducteurs (10) qui est disposé sur l'équipement de direction ou de commande et comporte au moins un brin conducteur de résistance ohmique importante ;
   - déterminer le passage du courant dans l'ensemble de conducteurs (10) ;
   - déterminer la composante réelle et la composante imaginaire de la résistance en courant alternatif instantanée de l'ensemble de conducteurs (10) ;
- Déterminer la capacité ou de la variation de capacité de l'ensemble de conducteurs (10) ;
- déterminer le déphasage ; et
- Évaluer les valeurs déterminées.

9. Procédé selon la revendication 8, **caractérisé en ce que** les étapes du procédé sont réalisées en continu.

10. Procédé selon la revendication 8 ou 9, **caractérisé en ce que** l'évaluation comprend au moins l'une des étapes suivantes :

   - Détecter si le dispositif de direction ou de commande est touché sur une grande surface ;
   - Détecter si le dispositif de direction ou de commande est touché de manière sélective ;
   - détecter la préhension ;
   - Détecter le nombre de touches simultanées ;
   - Localisation des positions de contacts multiples ;
   - déterminer la durée d'un contact ;
   - Identifier les gestes.

11. Procédé selon la revendication 10, **caractérisé en ce qu'**en fonction de l'évaluation, certaines fonctions sont déclenchées.

**Fig. 1**

**Fig. 2**

**Fig. 3**

**Fig. 4**

**IN DER BESCHREIBUNG AUFGEFÜHRTE DOKUMENTE**

**In der Beschreibung aufgeführte Patentdokumente**

- US 2014151356 A1
- US 2018106924 A1

- DE 102014016422 A1